# EUROPEAN PATENT APPLICATION

(11) **EP 4 761 478 A1**
(43) Date of publication of application: **17.06.2026**
(21) Application number: 25189503.3
(22) Date of filing: 15.07.2025
(51) Int. Cl.: H05K 7/14

(54) **HANDLE ASSEMBLY AND RELATED SUPPORTING MECHANISM**

(30) Priority: 11.12.2024 TW 113148374
(71) Applicant: King Slide Works Co., Ltd., Kaohsiung City 821 (TW); King Slide Technology Co., Ltd., 82151 Kaohsiung City (TW)
(72) Inventor: Chen, Ken-Ching, 821 Kaohsiung City (TW); Yang, Shun-Ho, 821 Kaohsiung City (TW); Li, Ting-Kai, 821 Kaohsiung City (TW); Wang, Chun-Chiang, 821 Kaohsiung City (TW)
(74) Representative: Straus, Alexander

(57) **Abstract**

A handle assembly(32) adapted for a carried object(24) is provided and includes a housing(52), a handle member(56) and a locking member(58). The housing(52) is detachably mounted on the carried object(24). The handle member(56) is movably mounted on the housing(52). The locking member(58) is movably mounted on the housing(52). The locking member(58) includes a locking portion(33). When the handle member(56) is in a first state(S1), the locking portion(33) of the locking member(58) protrudes out of the housing(52) in a transverse direction. When the handle member(56) is operated from the first state(S1) to a second state(S2), the handle member(56) drives the locking member(58) to retract the locking portion(33) of the locking member(58) into the housing(52). Besides, a related supporting mechanism is also provided.

## Description

### Field of the Invention

The present invention relates to a handle assembly and a supporting mechanism according to the pre-characterizing clauses of claims 1 and 8.

### Background of the Invention

In U.S. Patent No. 6,181,549 B1, it discloses a chassis retaining system adapted for supporting a chassis on a rack. The chassis and the rack conform to the Electronic Industries Association (EIA) standard. The rack typically includes a pair of front posts and a pair of rear posts, with each pair located on two opposite lateral sides of the rack. Each post includes a plurality of mounting holes for securing the chassis. The chassis retaining system includes two handles arranged on two opposite lateral sides of a front panel of the chassis. When the chassis is pushed into the rack from outside, a securing device on each handle is configured to pass through and engage with a corresponding mounting hole of the corresponding front post to retain the chassis in a stored state. Besides, a user interface device on each handle is configured to disengage the corresponding securing device from the corresponding front post.

The aforementioned chassis retaining system is suitable only for a rack conforming to the EIA standard. However, in order to meet various requirements, it becomes an important topic to develop a product suitable for a rack conforming to any other standard.

### Summary of the Invention

This is mind, the present invention aims at providing a handle assembly and a supporting mechanism adapted for supporting a carried object on a rack.

This is achieved by a handle assembly and a supporting mechanism according to claims 1 and 8. The dependent claims pertain to corresponding further developments and improvements.

As will be seen more clearly from the detail description following below, the claimed handle assembly is adapted for a carried object. The handle assembly includes a housing, a handle member and a locking member. The housing is detachably mounted on the carried object. The handle member is movably mounted on the housing. The locking member is movably mounted on the housing. The locking member includes a locking portion. When the handle member is in a first state, the locking portion of the locking member protrudes out of the housing in a transverse direction. When the handle member is operated from the first state to a second state, the handle member drives the locking member to retract the locking portion of the locking member into the housing.

Besides, the claimed supporting mechanism is adapted for supporting a carried object on a rack. The rack includes a first lateral post and a second lateral post .The supporting mechanism includes a first supporting member and the aforementioned handle assembly. The first supporting member includes a first longitudinal portion and a first supporting portion bent relative to the first longitudinal portion. The first longitudinal portion is configured to be mounted on the first lateral post, and the first supporting portion is configured to support the carried object. When the carried object is located at a retracted position relative to the rack and the handle member is in the first state, the locking portion of the locking member engages with the first lateral post for preventing the carried object from being pulled away from the retracted position in a first direction. When the handle member is operated from the first state to the second state, the handle member is configured to drive the locking member to disengage the locking portion of the locking member from the first lateral post for allowing the carried object to be pulled away from the retracted position in the first direction.

In summary, the present invention is configured to either lock the carried object to prevent the carried object from moving away from the retracted position relative to the rack, or release the carried object to allow the carried object to move away from the retracted position relative to the rack, by selectively protruding or retracting the locking member in the transverse direction, thereby meeting various application requirements.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof:
FIG. 1 is a diagram illustrating a supporting mechanism adapted for supporting a carried object on a rack according to an embodiment of the present invention,
FIG. 2 is a diagram illustrating the supporting mechanism and the carried object according to the embodiment of the present invention,
FIG. 3 is a partially exploded diagram illustrating the supporting mechanism, the carried object and the rack according to the embodiment of the present invention,
FIG. 4 is a diagram illustrating a first handle assembly and at least one connecting member according to the embodiment of the present invention,
FIG. 5 is a diagram illustrating the first handle assembly detachably mounted on the carried object with a handle member in a first state according to the embodiment of the present invention,
FIG. 6 is a diagram illustrating the first handle assembly detachably mounted on the carried object with the handle member in a second state according to the embodiment of the present invention,
FIG. 7 is a diagram illustrating the first handle assembly with the handle member in the first state according to the embodiment of the present invention,
FIG. 8 is a diagram illustrating the first handle assembly with the handle member in the second state according to the embodiment of the present invention,
FIG. 9 is a diagram illustrating the carried object located at a retracted position relative to the rack and locked by the supporting mechanism with the handle member in the first state according to the embodiment of the present invention,
FIG. 10 is an enlarged diagram illustrating an A portion shown in FIG. 9.
FIG. 11 is an enlarged diagram illustrating a B portion shown in FIG. 9.
FIG. 12 is a diagram illustrating the carried object located at the retracted position relative to the rack and released by the supporting mechanism with the handle member in the second state according to the embodiment of the present invention,
FIG. 13 is an enlarged diagram illustrating a C portion shown in FIG. 12.
FIG. 14 is a diagram illustrating the carried object located at an extended position relative to the rack with the handle member in the second state according to the embodiment of the present invention, and
FIG. 15 is an enlarged diagram illustrating a D portion shown in FIG. 14.

### Detailed Description

In the following detailed description of the preferred embodiments, reference is made to the accompanying drawings which form a part hereof, and in which is shown by way of illustration specific embodiments in which the invention may be practiced. In this regard, directional terminology, such as "top", "bottom", "left", "right", "front", "back", etc., is used with reference to the orientation of the Figure(s) being described. The components of the present invention can be positioned in a number of different orientations. As such, the directional terminology is used for purposes of illustration and is in no way limiting. Accordingly, the drawings and descriptions will be regarded as illustrative in nature and not as restrictive. Also, if not specified, the term "connect" is intended to mean either an indirect or direct mechanical connection. Thus, if a first device is connected to a second device, that connection may be through a direct mechanical connection, or through an indirect mechanical connection via other devices and connections. As used herein, the term "rack" may also refer to a cabinet structure unless otherwise specified.

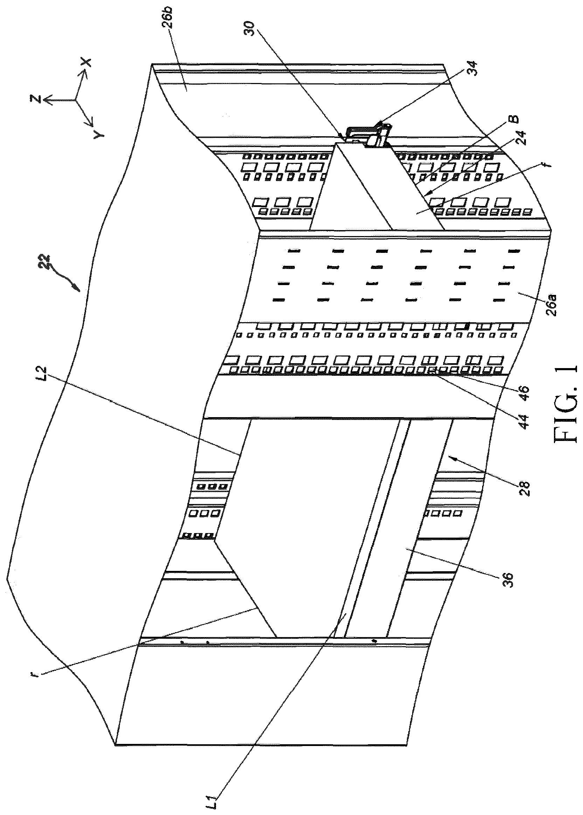

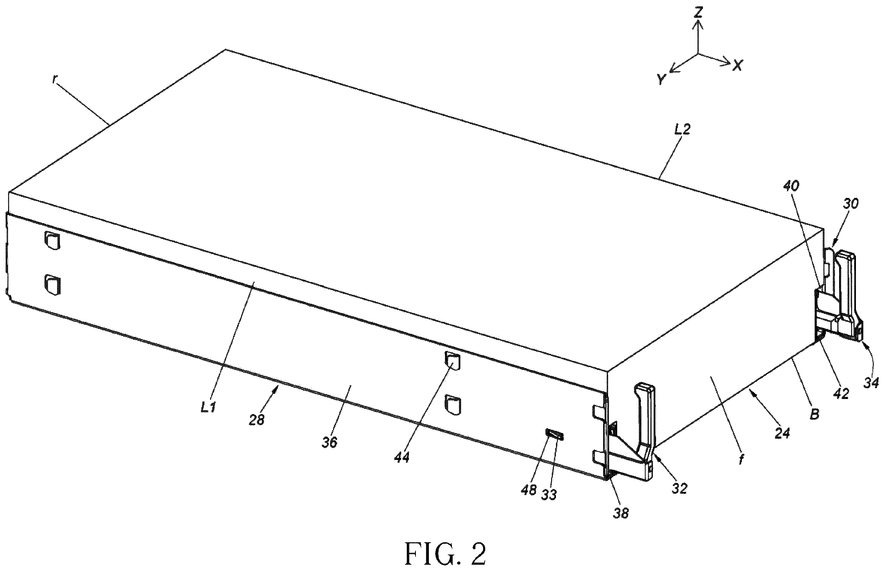

As shown in FIG. 1 and FIG. 2, a supporting mechanism is configured to be mounted between a rack 22 and a carried object 24 or a predetermined target, thereby supporting the carried object 24 or the predetermined target on the rack 22. For example, the rack 22 can conform to the Open Rack Standard defined by the Open Compute Project (OCP) organization. The rack 22 includes a first lateral post 26a and a second lateral post 26b opposite to the first lateral post 26a. For example, the first lateral post 26a and the second lateral post 26b can be a left lateral post and a right lateral post, respectively. Furthermore, in this embodiment, by way of example, the carried object 24 can be an electronic apparatus or a chassis. However, the present invention is not limited to this embodiment. The carried object 24 includes a first lateral portion L1 and a second lateral portion L2. For example, the first lateral portion L1 and the second lateral portion L2 can be a left lateral portion and a right lateral portion, respectively. Besides, the carried object 24 further includes a front end f and a rear end r.

The supporting mechanism includes a first supporting member 28, a second supporting member 30 and a first handle assembly 32. Preferably, the supporting mechanism further includes a second handle assembly 34.

The first supporting member 28 and the second supporting member 30 have substantially symmetrical structures. As shown in FIG. 1 and FIG. 2, the first supporting member 28 includes a first longitudinal portion 36 and a first supporting portion 38 bent relative to the first longitudinal portion 36. In this embodiment, by way of example, the first supporting portion 38 can be substantially perpendicularly bent relative to the first longitudinal portion 36. However, the present invention is not limited to this embodiment. The first longitudinal portion 36 is configured to be mounted on the first lateral post 26a, and the first supporting portion 38 is configured to support a bottom portion B of the carried object 24. Similarly, the second supporting member 30 includes a second longitudinal portion 40 and a second supporting portion 42 bent relative to the first longitudinal portion 36. In this embodiment, by way of example, the second supporting portion 42 can be substantially perpendicularly bent relative to the second longitudinal portion 40. However, the present invention is not limited to this embodiment. The second longitudinal portion 40 is configured to be mounted on the second lateral post 26b, and the second supporting portion 42 is configured to support the bottom portion B of the carried object 24.

Besides, as shown in FIG. 1 and FIG. 2, both the first longitudinal portion 36 of the first supporting member 28 and the second longitudinal portion 40 of the second supporting member 30 extend in a longitudinal direction. In this embodiment, by way of example, the longitudinal direction can be defined by a length direction of a supporting member, e.g., the first supporting member 28 or the second supporting member 30, and parallel to an X axis. A transverse direction can be defined by a lateral direction of the supporting member, e.g., the first supporting member 28 or the second supporting member 30, and parallel to a Y axis. A vertical direction can be defined by a height direction of the supporting member, e.g., the first supporting member 28 or the second supporting member 30, and parallel to a Z axis.

The first handle assembly 32 and the second handle assembly 34 have substantially symmetrical structures. The first handle assembly 32 is configured to be connected to the carried object 24. Preferably, the first handle assembly 32 is mounted on the carried object 24 and located adjacent to the first lateral portion L1. Furthermore, the second handle assembly 34 is configured to be connected to the carried object 24. Preferably, the second handle assembly 34 is mounted on the carried object 24 and located adjacent to the second lateral portion L2.

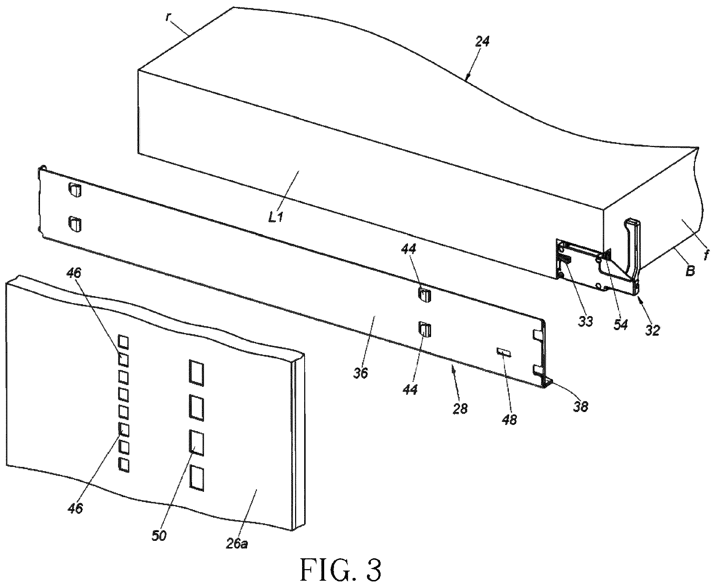

As shown in FIG. 3, the first longitudinal portion 36 of the first supporting member 28 and the second longitudinal portion 40 of the second supporting member 30 are mounted on the first lateral post 26a and the second lateral post 26b, respectively, in the same manner. A detailed description illustrating how the first longitudinal portion 36 of the first supporting member 28 is mounted on the first lateral post 26a is provided below. Preferably, a plurality of first mounting features 44 are arranged on the first longitudinal portion 36 of the first supporting member 28, and a plurality of second mounting features 46 are arranged on the first lateral post 26a for insertion of the plurality of the first mounting features 44, so as to connect the first supporting member 28 to the first lateral post 26a. For example, the first mounting feature 44 can be an engaging hook or an inserting pin, and the second mounting feature 46 can be a hole.

Preferably, a first predetermined space 48 is formed on the first longitudinal portion 36 of the first supporting member 28, and a second predetermined space 50 is formed on the first lateral post 26a. For example, the first predetermined space 48 and the second predetermined space 50 can be a first opening and a second opening, respectively. The first predetermined space 48 and the second predetermined space 50 are configured to cooperate with a locking portion 33 of the first handle assembly 32.

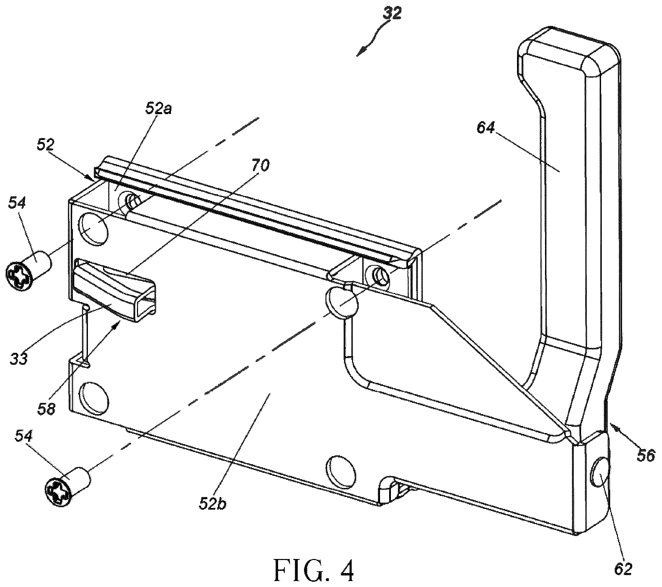

As shown in FIG. 3 and FIG. 4, the first handle assembly 32 and the second handle assembly 34 are connected to the carried object 24 in the same manner. A detailed description illustrating how the first handle assembly 32 is connected to the carried object 24 is provided below. Preferably, the first handle assembly 32 includes a housing 52 configured to be detachably mounted on the carried object 24. Specifically, the housing 52 includes a plurality of assembly portions, such as a first assembly portion 52a and a second assembly portion 52b, which are assembled together. The first assembly portion 52a and/or the second assembly portion 52b can be detachably mounted on the carried object 24 by at least one connecting member 54, such as a screw member or a bolt member.

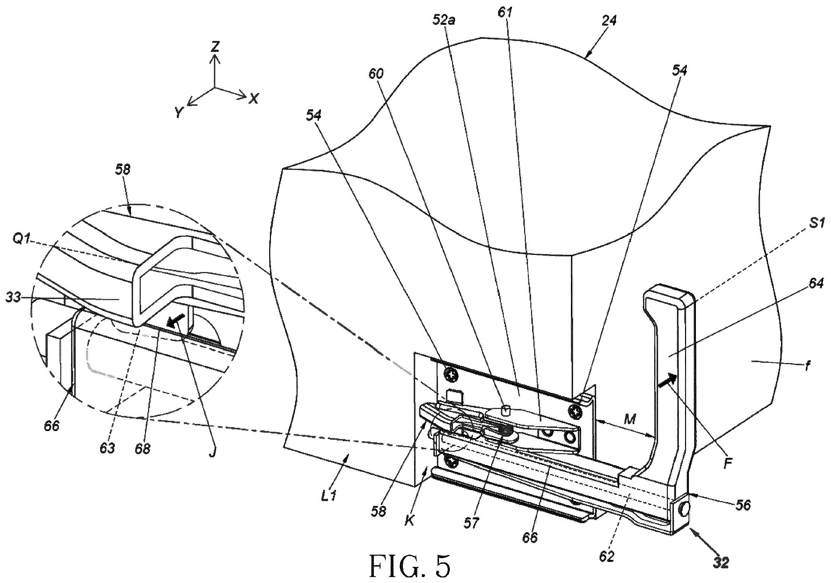

As shown in FIG. 5, an accommodating space K is formed on the first lateral portion L1 of the carried object 24, and the accommodating space K is configured to accommodate the first assembly portion 52a when the first handle assembly 32 is detachably mounted on the first lateral portion L1 of the carried object 24 by the connecting member 54, thereby preventing an increase in an overall width in the transverse direction.

The first handle assembly 32 further includes a handle member 56 and a locking member 58.

As shown in FIG. 4 and FIG. 5, both the locking member 58 and the handle member 56 are movably mounted on the housing 52. For example, the locking member 58 can be pivotally connected to an auxiliary member 61 on the first assembly portion 52a of the housing 52 via a first shaft 60 extending in a first predetermined direction, and the handle member 56 can be pivotally connected to the second assembly portion 52b of the housing 52 via a second shaft 62 extending in a second predetermined direction. In other words, a length direction of the first shaft 60 can be aligned with the first predetermined direction, and a length direction of the second shaft 62 can be aligned with the second predetermined direction. For example, the first predetermined direction and the second predetermined direction can be two perpendicular directions and defined by the vertical direction and the longitudinal direction, respectively. Furthermore, the auxiliary member 61 can be fixedly attached onto the first assembly portion 52a and therefore can be considered as a part of the first assembly portion 52a structurally. Understandably, in an alternative embodiment, the auxiliary member 61 can be integrally formed with the first assembly portion 52a.

The locking member 58 includes the locking portion 33 and a predetermined section 63. In this embodiment, by way of example, the predetermined section 63 can be a protruding section and bent relative to the locking portion 33. Furthermore, the handle member 56 is movable relative to the housing 52. When the handle member 56 is in a first state S1 relative to the housing 52, the locking member 58 is in a locking state Q1. The handle member 56 includes an operating portion 64 and a driving portion 66 connected to the operating portion 64. In this embodiment, by way of example, the operating portion 64 and the driving portion 66 can be substantially perpendicularly connected to each other to cooperatively form an L-shaped structure. However, the present invention is not limited to this embodiment. The operating portion 64 exceeds the front end f of the carried object 24 by a predetermined longitudinal distance M, thereby preventing any interference between the operating portion 64 and the carried object 24 during operation of the handle member 56.

Preferably, the first handle assembly 32 further includes a resilient member 57 configured to provide a resilient force to one of the locking member 58 and the handle member 56. In this embodiment, by way of example, the resilient member 57 can be a torsional spring configured to provide a resilient force J to the locking member 58. However, the present invention is not limited to this embodiment. Understandably, in an alternative embodiment, the resilient member 57 can be any other resilient structure, such as a resilient clip.

Preferably, as shown in FIG. 5, the driving portion 66 includes a driving section 68 located adjacent to the predetermined section 63 of the locking member 58, and the driving section 68 and the predetermined section 63 are configured to cooperate with each other.

Preferably, as shown in FIG. 5, when the locking member 58 is retained in the locking state Q1 in response to the resilient force J provided by the resilient member 57, the predetermined section 63 of the locking member 58 abuts against the driving section 68 to retain the handle member 56 in the first state S1.

Preferably, as shown in FIG. 5, when the handle member 56 is in the first state S1, a length direction of the operating portion 64 and a length direction of the driving portion 66 are aligned with the first predetermined direction, e.g., the vertical direction, and the second predetermined direction, e.g., the longitudinal direction, respectively.

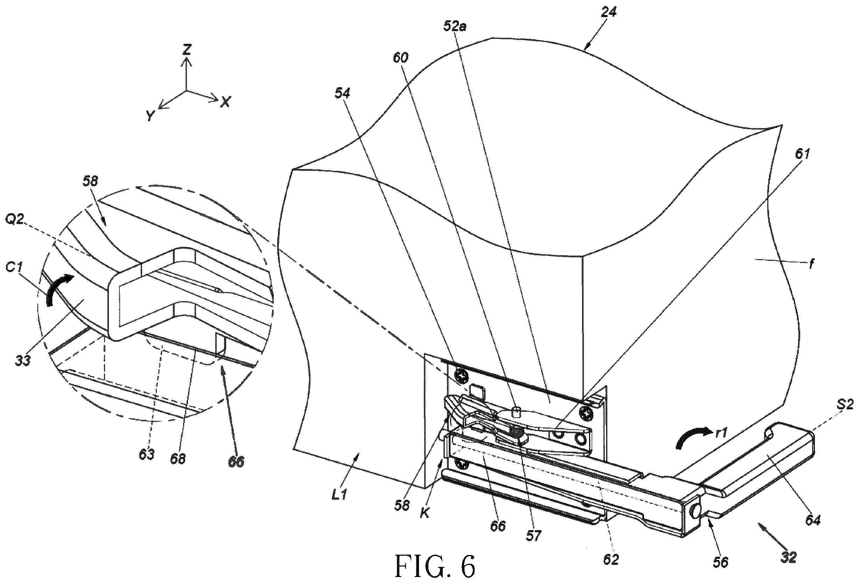

As shown in FIG. 5 and FIG. 6, when the handle member 56 is operated from the first state S1 to a second state S2, the handle member 56 is configured to drive the locking member 58 to move from the locking state Q1 to a releasing state Q2.

Specifically, when the handle member 56, e.g., the operating portion 64 of the handle member 56, is operated by an operating force F for overcoming the resilient force J provided by the resilient member 57, the handle member 56 can be driven to pivot from the first state S1 (as shown in FIG. 5) to the second state S2 (as shown in FIG. 6) in a first pivoting direction r1 about the second shaft 62. As a result, the handle member 56 pivoting from the first state S1 to the second state S2 drives the driving section 68 of the driving portion 66 of the handle member 56 to push the predetermined section 63 of the locking member 58 against the resilient force J provided by the resilient member 57, thereby driving the locking member 58 to pivot from the locking state Q1 (as shown in FIG. 5) to the releasing state Q2 (as shown in FIG. 6) in a releasing direction C1, and compressing the resilient member 57 to accumulate the resilient force J.

It should be noticed that, once the operating force F is released from the handle member 56, the resilient member 57 can release the resilient force J, thereby causing the locking member 58 to return from the releasing state Q2 (as shown in FIG. 6) to the locking state Q1 (as shown in FIG. 5) in response to the resilient force J, and driving the handle member 56 to return from the second state S2 (as shown in FIG. 6) to the first state S1 (as shown in FIG. 5).

Preferably, when the handle member 56 is in the second state S2, the length direction of the operating portion 64 and the length direction of the driving portion 66 are aligned with a third predetermined direction and the second predetermined direction, respectively. For example, the third predetermined direction can be defined by the transverse direction. In other words, the first predetermined direction, the second predetermined direction and the third predetermined direction can be perpendicular to one another.

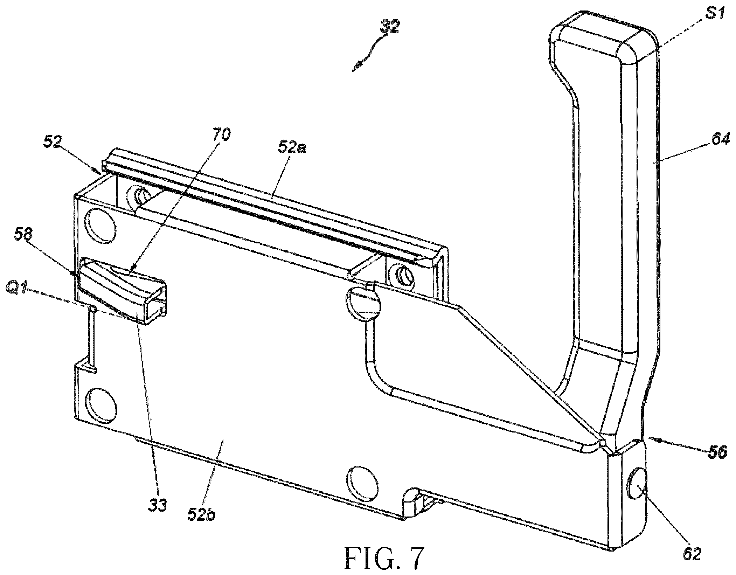

As shown in FIG. 5 and FIG. 7, when the handle member 56 is in the first state S1, the locking portion 33 of the locking member 58 protrudes out of the housing 52, e.g., through an auxiliary hole 70 on the second assembly portion 52b, in the transverse direction or the lateral direction in response to the resilient force J provided by the resilient member 57.

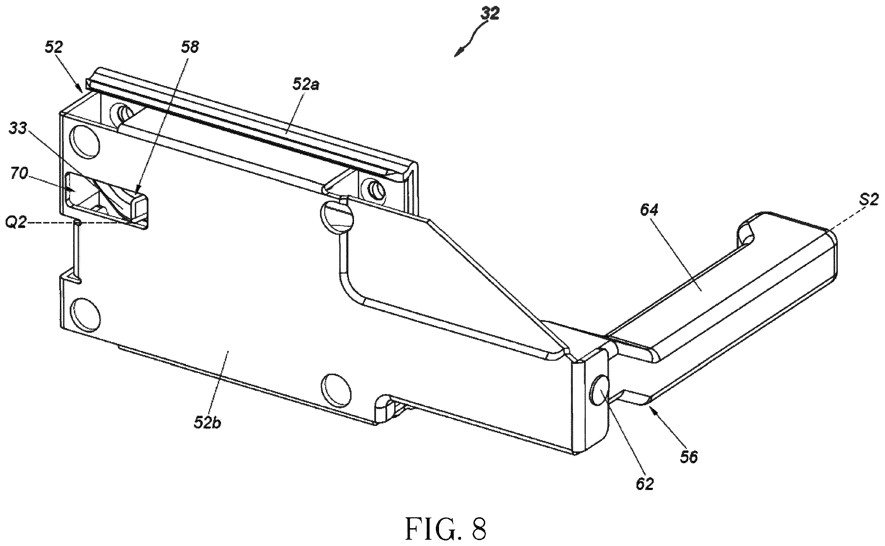

As shown in FIG. 6 and FIG. 8, when the handle member 56 is operated from the first state S1 to the second state S2, the handle member 56 drives the driving section 68 of the driving portion 66 to push the predetermined section 63 of the locking member 58, thereby driving the locking portion 33 of the locking member 58 to retract into the housing 52, e.g., through the auxiliary hole 70 on the second assembly portion 52b, in the transverse direction or the lateral direction to drive the locking member 58 from the locking state Q1 to the releasing state Q2.

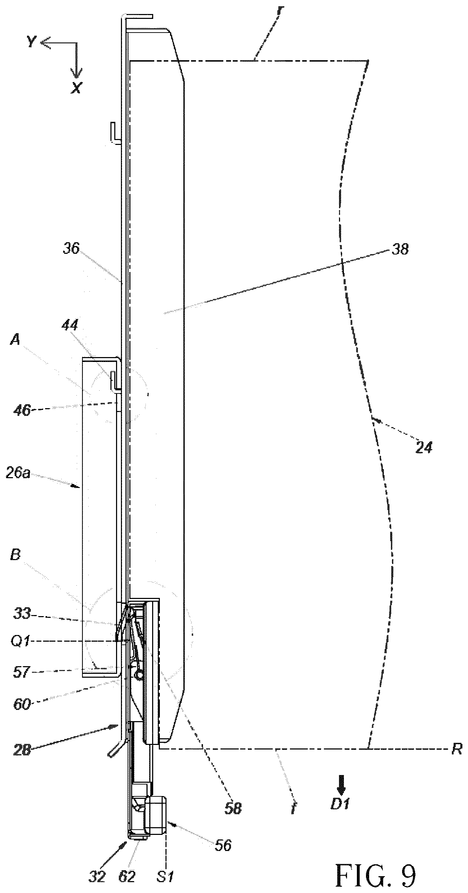

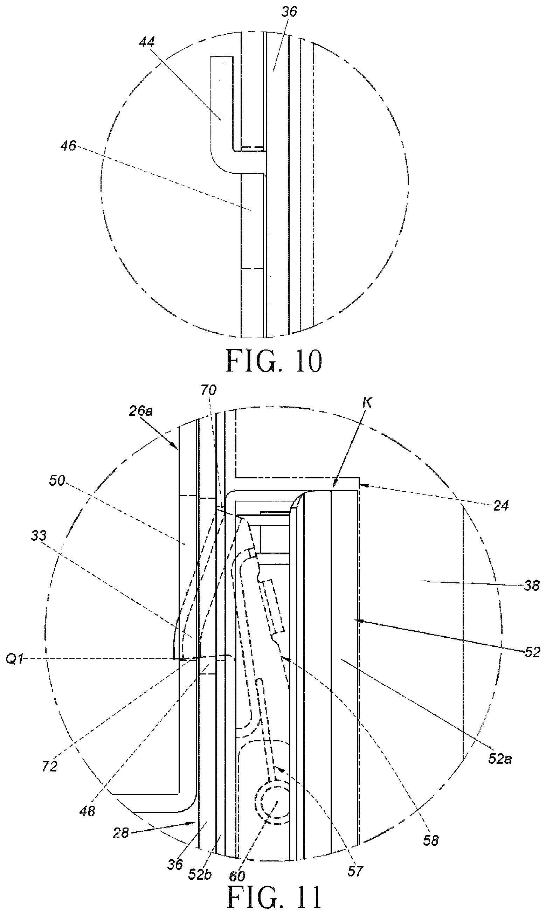

As shown in FIG. 9 to FIG. 11, the first supporting member 28 can be connected to the first lateral post 26a by an engagement of the corresponding first mounting features 44 and the corresponding second mounting features 46, e.g., an insertion of the corresponding engaging hook or the inserting pin into the hole, and the first supporting member 28 can support the bottom portion B of the carried object 24 by the first supporting portion 38.

When the carried object 24 is located at a retracted position R relative to the rack, e.g., the first lateral post 26a of the rack, and the handle member 56 is located in the first state S1, the locking portion 33 of the locking member 58 in the locking state Q1 engages with the first lateral post 26a for preventing the carried object 24 from being pulled away from the retracted position R in a first direction D1.

Preferably, when the carried object 24 is located at the retracted position R relative to the rack, e.g., the first lateral post 26a of the rack, and the handle member 56 is in the first state S1, the locking portion 33 of the locking member 58 in the locking state Q1 passes through the first predetermined space 48 on the first longitudinal portion 36 and the second predetermined space 50 on the first lateral post 26a to protrude out of the housing 52 in the transverse direction or the lateral direction to engage with a wall 72 of the second predetermined space 50 of the first lateral post 26a. As a result, the locking portion 33 of the locking member 58 in the locking state Q1 is blocked by the wall 72 of the second predetermined space 50 of the first lateral post 26a, thereby preventing the carried object 24 from being pulled away from the retracted position R in the first direction D1.

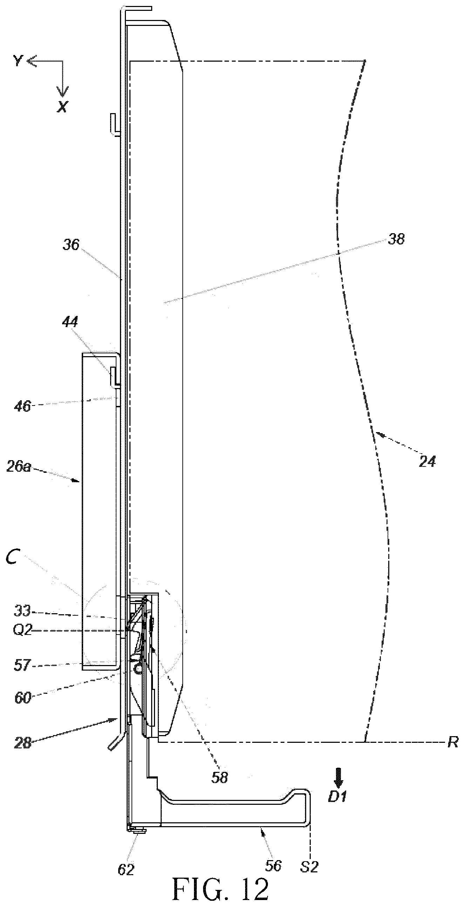

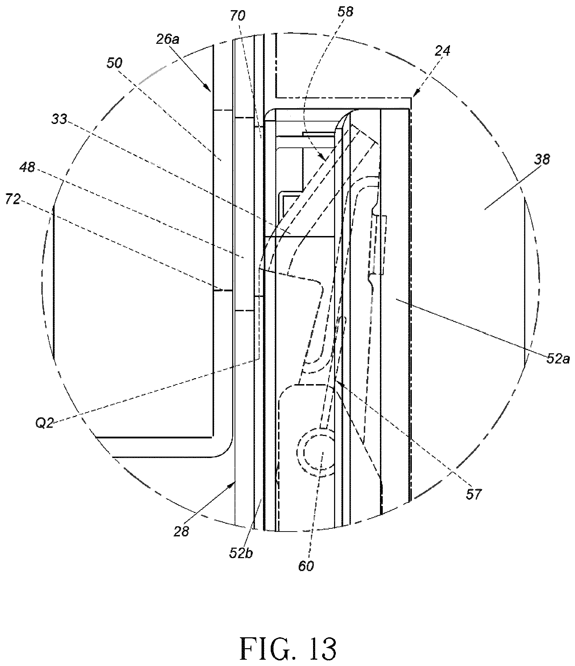

As shown in FIG. 12 and FIG. 13, when the handle member 56 is operated from the first state S1 to the second state S2, the handle member 56 is configured to drive the locking member 58 from the locking state Q1 to the releasing state Q2, thereby driving the locking portion 33 of the locking member 58 to disengage from the first lateral post 26a for allowing the carried object 24 to be pulled away from the retracted position R in the first direction D1.

Preferably, when the carried object 24 is located at the retracted position R relative to the rack, e.g., the first lateral post 26a of the rack, and the handle member 56 is operated from the first state S1 to the second state S2, the driving portion 66 of the handle member 56 drives the locking member 58 from the locking state Q1 to the releasing state Q2 (as shown in FIG. 6), thereby driving the locking portion 33 of the locking member 58 to disengage from the wall 72 of the second predetermined space 50 of the first lateral post 26a. As a result, the locking portion 33 of the locking member 58 in the releasing state Q2 is no longer blocked by the wall 72 of the second predetermined space 50 of the first lateral post 26a, thereby allowing the carried object 24 to be pulled away from the retracted position R in the first direction D1.

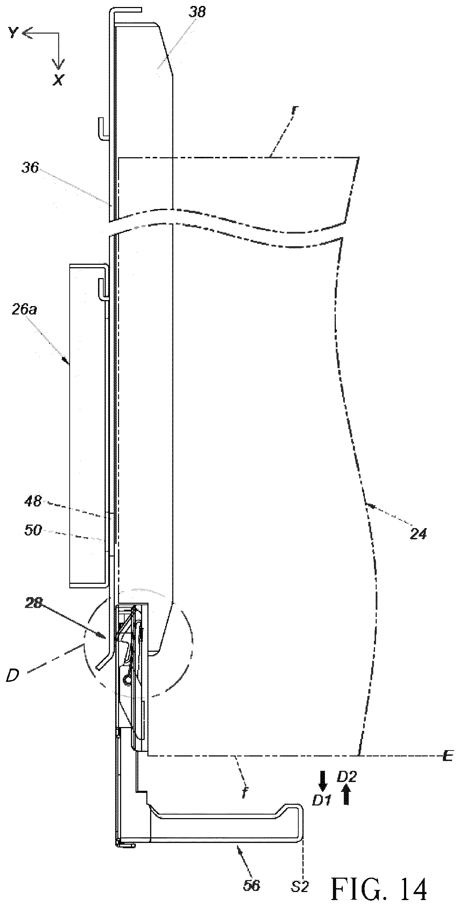

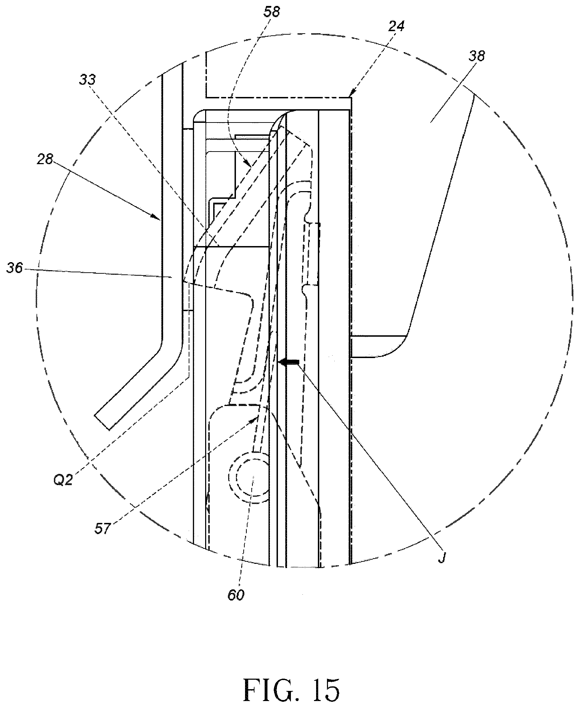

As shown in FIG. 14 and FIG. 15, after the locking member 58 is moved to the releasing state Q2 to disengage from the first lateral post 26a, the carried object 24 can be pulled away from the retracted position R to a predetermined position, e.g., an extended position E, in the first direction D1. When the carried object 24 is located at the extended position E, the locking portion 33 of the locking member 58 abuts against the first longitudinal portion 36 of the first supporting member 28, such that the resilient member 57 accumulates the resilient force J.

Furthermore, when the carried object 24 is pushed from the extended position E back to the retracted position R in a second direction D2 opposite to the first direction D1, the locking portion 33 is aligned with the first predetermined space 48 on the first longitudinal portion 36 and the second predetermined space 50 on the first lateral post 26a, such that the locking portion 33 of the locking member 58 can engage with the wall 72 of the second predetermined space 50 of the first lateral post 26a in response to the resilient force J provided by the resilient member 57 to lock the carried object 24 at the retracted position R again.

It should be noticed that the locking and releasing relationship between the second handle assembly and the second lateral post is identical to the locking and releasing relationship between the first handle assembly and the first lateral post. Therefore, a further detailed description is omitted herein for simplicity.

From the above, the supporting mechanism of the present invention includes the following characteristics.
1. The supporting mechanism can include the first handle assembly 32 and/or the second handle assembly 34 detachably mounted on the carried object 24 selectively according to practical demands, thereby offering flexibility in use.
2. The supporting mechanism utilizes the supporting member, e.g., the first supporting member 28 or the second supporting member 30, mounted on the rack and the handle assembly, e.g., the first handle assembly 32 or the second handle assembly 34, connected to the carried object 24 for selectively either preventing the carried object 24 from being pulled away from the retracted position R or allowing the carried object 24 to be pulled away from the retracted position R by operating the handle member 56 between the first state S1 and the second state S2. This configuration allows the rack to conform to the Open Rack Standard defined by the Open Compute Project (OCP) organization, thereby meeting various application requirements.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A handle assembly (32) adapted for a carried object (24), the handle assembly (32) **characterized by**:
a housing (52) configured to be detachably mounted on the carried object (24);
a handle member (56) movably mounted on the housing (52); and
a locking member (58) movably mounted on the housing (52), the locking member (58) comprising a locking portion (33);
wherein when the handle member (56) is in a first state (S1), the locking portion (33) of the locking member (58) protrudes out of the housing (52) in a transverse direction;
wherein when the handle member (56) is operated from the first state (S1) to a second state (S2), the handle member (56) drives the locking member (58) to retract the locking portion (33) of the locking member (58) into the housing (52).

2. The handle assembly (32) of claim 1, **characterized in that** the handle member (56) comprises an operating portion (64) exceeding a front end (f) of the carried object (24) by a predetermined longitudinal distance (M).

3. The handle assembly (32) of claim 2, **characterized in that** the handle member (56) further comprises a driving portion (66) connected to the operating portion (64) and configured to push the locking member (58) for driving the locking member (58) to retract the locking portion (33) of the locking member (58) into the housing (52), and when the handle member (56) is in the first state (S1), a length direction of the operating portion (64) and a length direction of the driving portion (66) are aligned with a first predetermined direction and a second predetermined direction, respectively.

4. The handle assembly (32) of claim 3, further **characterized by** a first shaft (60), the locking member (58) being pivotally connected to the housing (52) by the first shaft (60), and a length direction of the first shaft (60) being aligned with the first predetermined direction.

5. The handle assembly (32) of claim 4, further **characterized by** a second shaft (62), the handle member (56) being pivotally connected to the housing (52) by the second shaft (62), and a length direction of the second shaft (62) being aligned with the second predetermined direction.

6. The handle assembly (32) of any of claims 3 to 5, **characterized in that** the second predetermined direction is parallel to a longitudinal direction perpendicular to the transverse direction, and the first predetermined direction and the second predetermined direction are perpendicular to each other.

7. The handle assembly (32) of any of claims 1 to 6, further **characterized by** a resilient member (57) configured to provide a resilient force to one of the locking member (58) and the handle member (56) for driving the locking portion (33) of the locking member (58) to protrude out of the housing (52) in the transverse direction in response to the resilient force provided by the resilient member (57).

8. A supporting mechanism adapted for supporting a carried object (24) on a rack (22), the rack (22) comprising a first lateral post (26a) and a second lateral post (26b), the supporting mechanism **characterized by**:
a first supporting member (28) comprising a first longitudinal portion (36) and a first supporting portion (38) bent relative to the first longitudinal portion (36), the first longitudinal portion (36) being configured to be mounted on the first lateral post (26a), and the first supporting portion (38) being configured to support the carried object (24);and
the handle assembly (32) of any of claims 1 to 7;
wherein when the carried object (24) is located at a retracted position (R) relative to the rack (22) and the handle member (56) is in the first state (S1), the locking portion (33) of the locking member (58) engages with the first lateral post (26a) for preventing the carried object (24) from being pulled away from the retracted position (R) in a first direction (D1);
wherein when the handle member (56) is operated from the first state (S1) to the second state (S2), the handle member (56) is configured to drive the locking member (58) to disengage the locking portion (33) of the locking member (58) from the first lateral post (26a) for allowing the carried object (24) to be pulled away from the retracted position (R) in the first direction (D1).

9. The supporting mechanism of claim 8, **characterized in that** the handle assembly (32) is located adjacent to a first lateral portion (L1) of the carried object (24).

10. The supporting mechanism of claim 9, **characterized in that** at least a portion of the housing (52) is mounted on the first lateral portion (L1) of the carried object (24) and located inside an accommodating space (K) concavely formed on the first lateral portion (L1) of the carried object (24).

11. The supporting mechanism of any of claims 8 to 10, **characterized in that** when the handle member (56) is in the first state (S1), the locking portion (33) of the locking member (58) of the handle assembly (32) passes through a first predetermined space (48) on the first longitudinal portion (36) and a second predetermined space (50) on the first lateral post (26a) to engage with a wall (72) of the second predetermined space (50) for preventing the carried object (24) from being pulled away from the retracted position (R) in the first direction (D1), and when the carried object (24) is located at the retracted position (R) relative to the rack (22) and the handle member (56) is operated from the first state (S1) to the second state (S2), the handle member (56) drives the locking member (58) to disengage the locking portion (33) of the locking member (58) from the wall (72) of the second predetermined space (50).

12. The supporting mechanism of any of claims 8 to 11, further **characterized by** a second supporting member (30) and another handle assembly (34), the second supporting member (30) comprising a second longitudinal portion (40) and a second supporting portion (42) bent relative to the second longitudinal portion (40), the second longitudinal portion (40) being configured to be mounted on the second lateral post (26b), and the second supporting portion (42) being configured to support the carried object (24), the handle assembly (32) and the another handle assembly (34) being mounted on the carried object (24) and located adjacent to two lateral portions of the carried object (24).

13. The supporting mechanism of claim 12, **characterized in that** the handle assembly (32) and the another handle assembly (34) have substantially symmetrical structures.

14. The supporting mechanism of any of claims 8 to 13, **characterized in that** a plurality of first mounting features (44) are arranged on the first longitudinal portion (36) of the first supporting member (28), and a plurality of second mounting features (46) are arranged on the first lateral post (26a) for insertion of the plurality of the first mounting features (44), so as to connect the first supporting member (28) to the first lateral post (26a).

15. The supporting mechanism of any of claims 8 to 14, **characterized in that** the first longitudinal portion (36) of the first supporting member (28) is configured to abut against the locking portion (33) of the locking member (58) when the carried object (24) is moved to a predetermined position from the retracted position (R).
